# EUROPEAN PATENT APPLICATION

(11) **EP 0 773 426 A1**
(43) Date of publication of application: **14.05.1997**
(21) Application number: 96919983.5
(22) Date of filing: 29.05.1996
(51) Int. Cl.: G01B 11/24

(54) **OBJECT OBSERVATION APPARATUS AND METHOD**

(30) Priority: 31.05.1995 JP 155551/95
(71) Applicant: OMRON CORPORATION, Kyoto-shi, Kyoto 616 (JP)
(72) Inventor: MIYAKE, Tamio, Ukyo-ku, Kyoto-shi, Kyoto 616 (JP); ISHIDA, Tomoya, Ukyo-ku, Kyoto-shi, Kyoto 616 (JP)
(74) Representative: Kahler, Kurt, Dipl.-Ing.
(86) International application number: JP9601437
(87) International publication number: WO9638709

(57) **Abstract**

An apparatus includes light projecting means 1-3 for projecting light beams to an observation target portion of an object through a predetermined path, recursive reflecting means 4-7 for reflecting, in an incident direction, the incoming light beams reflected by the observation target portion, and light receiving means 8 and 9 for receiving the light beams reflected by the recursive reflecting means and the observation target portion and coming through the predetermined light path. This can improve maintenance properties, reduce cost and improve accuracy in inspection.

## Description

### TECHNICAL FIELD

The present invention relates to an apparatus and a method for observing an object, and in particular for observing portions having mirror reflection properties such as soldered portions or the like on part mounted boards, and, if necessary, inspecting the portions for defects based on the observation.

### BACKGROUND ART

An object observing apparatus of this type is disclosed in Japanese Patent Laying-Open No. 6-1173 (1994). In this object observing apparatus, trichromatic light beams of red, green and blue are projected at different elevation angles to an observation target portion, i.e., portion to be observed of an object which includes a portion having mirror reflection properties. The observation of the target portion is performed based on a color image produced from the reflected light beams. For this purpose, the above apparatus employs light projecting means, light receiving means and others.

The light projecting means includes three annular fluorescent light sources, i.e., red, green and blue light sources, from which light beams of three colors are projected to the observation target portion at different elevation angles, respectively. These trichromatic light sources have light intensities which are adjusted in advance such that three kinds of light beams have low wavelength light emission energies producing complete white light when mixed at the position of the object. The light receiving means is a color TV camera such as a CCD camera, and obtains color image signals by capturing light beams reflected from the observation target portion.

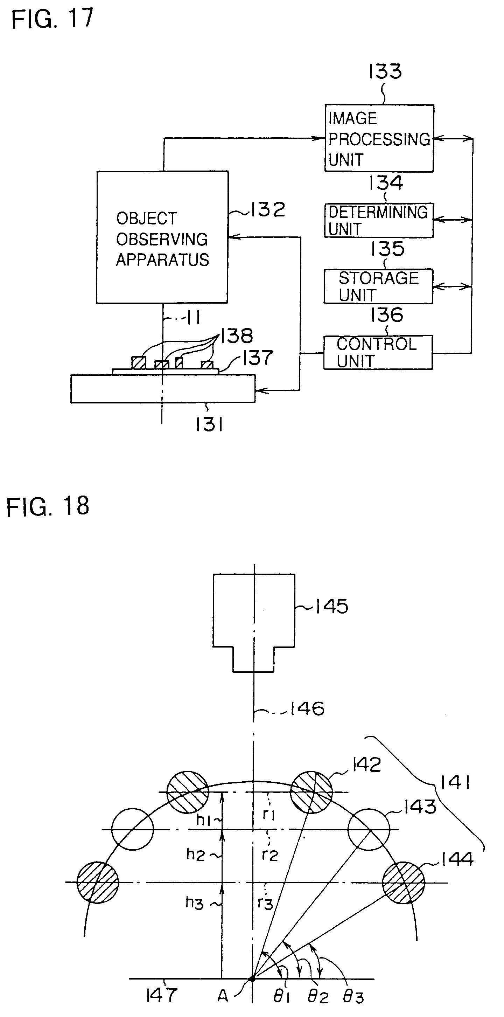

Fig. 18 shows a structure of the light projecting means. In this figure, a light projector 141 includes annular light sources, i.e., red light source 142, green light source 143 and blue light source 144, which are arranged concentrically with a light receiving axis 146 of a light receiver 145, but have different radii r₁, r₂ and r₃ as well as different heights h₁, h₂ and h₃ from a reference surface 147, respectively. Thereby, elevation angles of them with respect to reference surface 147 at a crossing point A between light receiving axis 146 and reference surface 147 take on different values θ₁, θ₂ and θ₃ (θ₁>θ₂>θ₃). Further, distances from the point A to the respective light sources are substantially equal to each other.

According to this object observing apparatus, obliquely projected light beams of different colors are correctly reflected in directions corresponding to incident angles by curved surface element portions, which form various inclined surfaces with respect to reference surface 147, have mirror reflection properties and are defined, e.g., on a soldered portion on a part mounted board.

The curved surface element, of which reflection direction is coincident with the direction of light receiving axis 146 of the light receiver (normal to the reference surface) is colored in the color image to have a color corresponding the light source color, so that the curved surface element having an inclination similar to the flat portion is colored red, and the curved surface element having a steep inclination is colored blue. The curved surface element having a middle inclination is colored green. Thus, portions having the mirror reflection properties are colored to have colors of the color light sources in accordance with their configurations of three-dimensional curved surfaces, respectively.

Since the light beams of three colors have low wave length light emission energy distribution providing complete white light when mixed, portions having irregular reflection properties are colored to have specific colors in the color image. Further, the apparatus are also utilized as inspection conducting means for inspecting the observation target portions such as soldered portions for defects based on the color image thus obtained.

The conventional object observing apparatus described above requires three color light sources for providing visible light beams of three colors, so that the apparatus requires the light projector of a complicated structure, and also suffers from problems relating to maintenance and cost.

Due to variation or deviation in wavelength characteristics and light intensity between the respective color light sources, the light intensities of the color light sources must be adjusted to provide white light, when mixed, in every apparatus. This adjustment of light intensity is difficult and requires a time-consuming work.

The present invention has been developed to overcome the above-noted conventional problems, and it is an object of the invention to improve the maintenance properties including a workability for adjustment and reduce a cost. It is also an object of the invention to improve accuracy in observation and/or inspection.

### DISCLOSURE OF THE INVENTION

The object observing apparatus of the invention includes light projecting means for projecting light beams through a predetermined light path to an observation target portion of an object; recursive reflecting means for reflecting in an incident direction the incoming light beams reflected by the observation target portion; and light receiving means for receiving the light beams reflected by the recursive reflecting means and the observation target portion and coming through the predetermined light path.

According to the object observing apparatus of the invention, therefore, the light projecting means projects the lights downward toward the observation target portion, the light beams reflected by the observation target portion are reflected in its incident direction by the recursive reflecting means, and the light receiving means receives the light beams reflected by the observation target portion through the recursive reflecting means. Thereby, the light source can be a single light source, so that it is possible to reduce a cost, improve maintenance properties and simplify a work of adjusting the light source. Also, accuracy in observation can be improved.

Preferably, the recursive reflecting means is arranged annularly with respect to a center of the observation target portion.

Preferably, the recursive reflecting means is arranged in a doom-like form with respect to a center of the observation target portion.

Preferably, the recursive reflecting means are plural in number and are arranged at positions forming different elevation angles at a center of the observation target portion.

Preferably, the recursive reflecting means are plural in number and are arranged annularly at a plurality of positions with respect to a center of the observation target portion, respectively, the positions forming different elevation angles at a center of the observation target portion.

More preferably, the recursive reflecting means reflects a specific wavelength of the light beams reflected by the observation target portion.

Preferably, the specific wavelength reflected by the recursive reflecting means continuously changes in accordance with the elevation angle at the center of the observation target portion.

More preferably, the plurality of recursive reflecting means reflect the light beams of different specific wavelengths, respectively.

More preferably, the light projecting means has a light source and a beam splitter for reflecting the light beams radiated from the light source to project the same to the observation target portion and passing the light beams reflected by the observation target portion therethrough to apply the same to the light receiving means.

Preferably, the light projecting means has a light source arranged near a light receiving axis of the light receiving means and projecting the light beams to the observation target portion.

More preferably, the light source of the light projecting means is an annular light source concentrical with the light receiving axis of the light receiving means.

According to another aspect of the invention, an object observing apparatus includes light projecting means for projecting white light beams emitted from a white light source to an observation target portion of an object through a predetermined light path; a plurality of recursive reflecting means arranged annularly at positions forming different elevation angles at a center of the observation target portion for reflecting, in the incident directions, at least two color wavelength components of the incoming white light beams reflected by the observation target portion; and light receiving means for distinguishing and receiving the at least two color wavelength components reflected by the recursive reflecting means and the observation target portion and coming through the predetermined light path.

According yet another aspect of the invention, an object observing apparatus includes light projecting means for projecting white light beams emitted from a white light source to an observation target portion of an object through a predetermined light path; a plurality of recursive reflecting means arranged annularly at positions forming different elevation angles at a center of the observation target portion for reflecting in incident directions a red wavelength component, a green wavelength component and a blue wavelength component of the incoming white light beams reflected by the observation target portion, respectively; and light receiving means for distinguishing and receiving red, green and blue light beams reflected by the recursive reflecting means and the observation target portion and coming through the predetermined light path.

A further another aspect of the invention, an object observing apparatus includes light projecting means for projecting white light beams emitted from a white light source to an observation target portion of an object through a predetermined light path; recursive reflecting means arranged in a doom-like form with respect to a center of the observation target portion for reflecting, in an incident direction, light beams of a specific wavelength of the incoming white light beams reflected by the observation target portion such that the specific wavelength continuously changes in accordance with the elevation angle at the center of the observation target portion; and light receiving means for receiving light beams of the specific wavelength reflected by the recursive reflecting means and the observation target portion and coming through the predetermined light path.

According to a further aspect of the invention, an object observing apparatus includes light projecting means for successively projecting light beams of at least two color wavelength components to an observation target portion of an object through a predetermined light path with a predetermined time interval; at least two recursive reflecting means arranged at positions forming different elevation angles at a center of the observation target portion for reflecting in incident directions the light beams of the at least two incoming color wavelength components reflected by the observation target portion; and light receiving means having a two-dimensional light receiving element successively receiving the at least two color wavelength components reflected by the recursive reflecting means and the observation target portion and coming through the predetermined light path.

According to a further aspect of the invention, an object observing apparatus includes light projecting means for successively projecting red, green and blue light beams through a predetermined light path to an observation target portion of an object, the red, green and blue light beams being produced by passing, respectively, through red, green and blue filters successively arranged on a light projection axis of a white light source with a predetermined time interval; a plurality of recursive reflecting means arranged at positions forming different elevation angles at a center of the observation target portion, for reflecting, in incident directions, the red, green and blue wavelength components of the incoming color light beams reflected by the observation target portion, respectively; and light receiving means having a monochromatic TV camera successively receiving the color wavelength components reflected by the recursive reflecting means and the observation target portion and coming through the predetermined light path.

According to a further aspect of the invention, an object observing apparatus includes light projecting means for projecting white light beams emitted from a white light source to an observation target portion of an object through a predetermined light path; a plurality of recursive reflecting means arranged at positions forming different elevation angles at a center of the observation target portion for reflecting, in incident directions, red, green and blue wavelength components of the incoming white light beams reflected by the observation target portion, respectively; and light receiving means successively receiving red, green and blue light beams passed, respectively, through red, green and blue filters successively arranged on a light receiving axis of a monochromatic TV camera with a predetermined time interval, the monochromatic TV camera receiving the light wavelength components reflected by the recursive reflecting means and the observation target portion and coming through the predetermined light path.

According to a further aspect of the invention, an object observing apparatus includes light projecting means for successively projecting light beams emitted from a trichromatic light source to an observation target portion of an object through a predetermined path, the trichromatic light source being operable to change its light beams into red, green and blue with a predetermined time interval; a plurality of recursive reflecting means arranged at positions forming different elevation angles at a center of the observation target portion for reflecting, in incident directions, red, green and blue wavelength components of the incoming color light beams reflected by the observation target portion, respectively; and light receiving means having a monochromatic TV camera successively receiving the respective color wavelength components reflected by the recursive reflecting means and the observation target portion and coming through the predetermined light path.

According to a further aspect of the invention, an object observing apparatus includes light projecting means for projecting light beams of at least two color wavelength components simultaneously or with a predetermined time interval to an observation target portion of an object through a predetermined light path; at least two recursive reflecting means arranged at positions forming different elevation angles at a center of the observation target portion for reflecting, in incident directions, at least two incoming color wavelength components reflected by the observation target portion; and light receiving means having a two-dimensional light receiving element successively receiving at least two color wavelength components reflected by the recursive reflecting means and the observation target portion and coming through the predetermined light path.

Preferably, the apparatus further includes inspection conducting means for detecting a mirror reflection portion of the observation target portion based on data of the light received by the light receiving means, and inspecting the observation target portion for a defect based on a result of the detection.

According to the object observing apparatus of the invention, the inspection conducting means detects and specifies the mirror reflection portion of the observation target portion based on the data of light received by the light receiving means, and inspects the observation target portion for a defect. Therefore, it is possible to reduce a cost of the apparatus in an inspection stage, improve maintenance properties and simplify an adjusting work. Further, the accuracy in inspection can be improved.

According to a further aspect of the invention, a method of observing an object including the steps of: projecting light beams from light projecting means through a predetermined light path to an observation target portion of an object; reflecting, in an incident direction, incoming light beams reflected by the observation target portion by recursive reflecting means; and receiving by light receiving means the light beams reflected by the recursive reflecting means and the observation target portion and coming through the predetermined light path.

According to the above method of observing the object, the light projecting means projects downward the light beams to the observation target portion, the recursive reflecting means reflects, in the incident direction, the light beams reflected by the observation target portion, the light receiving means receives the light beams reflected by the recursive reflecting means and the observation target portion, whereby only a single light source can be employed as the light source. Therefore, the cost can be reduced, the maintenance properties can be improved, and the adjusting of the light source can be simplified. Further, accuracy in observation can be improved.

Preferably, the light beams reflected by the observation target portion are reflected in the incident direction by the recursive reflecting means arranged annularly with respect to a center of the observation target portion.

Preferably, the light beams reflected by the observation target portion are reflected in the incident direction by the recursive reflecting means arranged in a doom-like form with respect to a center of the observation target portion.

Preferably, the light beams reflected by the observation target portion are reflected in the incident directions by the plurality of recursive reflecting means located at positions forming different elevation angles at a center of the observation target portion, respectively.

More preferably, the light beams reflected by the observation target portion are reflected in the incident directions by the plurality of recursive reflecting means arranged annularly with respect to a center of the observation target portion and located at positions forming different elevation angles at the center of the observation target portion, respectively.

More preferably, the recursive reflecting means is operable to reflect the light beams of a specific wavelength reflected by the observation target portion, and reflects, in the incident direction, the specific wavelength component of the light beams reflected by the observation target portion.

More preferably, the recursive reflecting means is operable to change continuously a specific wavelength reflected thereby in accordance with the elevation angle at a center of the observation target portion, and reflects, in the incident direction, the wavelength component corresponding to the elevation angle of the light beams reflected by the observation target portion.

More preferably, the recursive reflecting means is operable to reflect specific wavelengths partially differing from each other, and reflects, in the incident direction, the specific wavelength components of the light beams reflected by the observation target portion.

According to a further aspect of the invention, a method of observing an object includes the steps of: projecting white light beams to an observation target portion of an object through a predetermined light path from light projecting means having a white light source; reflecting, in incident directions, by a plurality of recursive reflecting means red, green and blue wavelength components of the incoming white light beams reflected by the observation target portion, respectively, the plurality of recursive reflecting means being arranged annularly at positions forming different elevation angles at a center of the observation target portion; and receiving by light receiving means the red, green and blue light beams reflected by the recursive reflecting means and the observation target portion and coming through the predetermined light path.

According to a further aspect of the invention, a method of observing an object includes the steps of: projecting white light beams from light projecting means having a white light source to an observation target portion of an object through a predetermined light path; reflecting, in an incident direction, light beams of a specific wavelength of the incoming white light beams reflected by the observation target portion by recursive reflecting means arranged in a doom-like form with respect to a center of the observation target portion, the specific wavelength being variable in accordance with an elevation angle at a center of the observation target portion; and receiving the light beams of the specific wavelength reflected by the recursive reflecting means and the observation target portion and coming through the predetermined light path.

According to a further aspect of the invention, a method of observing an object includes the steps of: projecting light beams of at least two color wavelength components simultaneously or with a predetermined time interval from light projecting means to an observation target portion of an object through a predetermined light path; reflecting the at least two incoming color wavelength components reflected at the observation target portion by at least two recursive reflecting means arranged at positions forming different elevation angles at a center of the observation target portion; and successively receiving, by light receiving means having a two-dimensional light receiving element, the at least two color wavelength components reflected by the recursive reflecting means and the observation target portion and coming through the predetermined light path.

According to a further aspect of the invention, a method of observing an object includes the steps of: successively projecting light beams of at least two light wavelength components with a predetermined time interval to an observation target portion of an object from light projecting means through a predetermined light path; reflecting, in incident directions, the at least two incoming color wavelength components reflected by the observation target portion by at least two recursive reflecting means arranged at positions forming different elevation angles at a center of the observation target portion; and successively receiving by light receiving means having a two-dimensional light receiving element the at least two color wavelength components reflected by the recursive reflecting means and the observation target portion and coming through the predetermined light path.

Preferably, the method further includes the steps of: detecting, by inspection conducting means, a mirror reflection portion of the observation target portion based on data of the light received by the light receiving means, and inspecting the observation target portion for a defect based on a result of the detection.

According to the method of observing the object of the invention, the inspection conducting means detects and specifies the mirror reflection portion of the observation target portion based on the data of light received by the light receiving means, and inspects the observation target portion for a defect. Thereby, it is possible to reduce a cost of the apparatus in an inspection stage, improve maintenance properties and simplify an adjusting work. Further, the accuracy in inspection can be improved.

According to the apparatus and method of observing the object of the invention, a conventional work which has been required for adjusting color light sources for obtaining white light is not required, so that a work of adjusting the light source can be simplified. Also, the reflection wavelengths of the respective recursive reflectors are not required to be a combination of colors providing white light when mixed in contrast to the prior art, and can be arbitrarily selected.

A reflector reflecting light beams radiated from the light source may be arranged at a rear side of the light source of the light projecting means, whereby a utilization efficiency of the light source can be improved double.

In the observation target portion including the portion having mirror reflection properties, if it is necessary to determine schematically a configuration and a position of the mirror reflection portion and a color image of a periphery is not required, the light receiving means can use a monochromatic TV camera instead of a color TV camera. In this case, a recursive reflector which does not have wavelength characteristics and is operable to reflect all the wavelength components of the incident light beams in the incident direction may be used instead of the recursive reflector having wavelength characteristics. Thereby, the cost can be reduced.

The light source of the light projecting means may be arranged at the vicinity of the light receiving axis of the light receiving means, whereby a beam splitter is not required, so that the cost can be reduced, and the maintenance properties can be improved.

The apparatus may use a recursive reflector having a doom-like form and reflecting a specific wavelength, which continuously changes in accordance with the elevation angle at the observation target portion, and the observation target portion in the color image produced by the light receiving means may be continuously colored in a color changing in accordance with the three-dimensional configuration of the observation target portion. This allows more precise observation.

Recursive reflectors, which receive, in incident directions, the red, green and blue wavelength components of the incident light beams, respectively, may be concentrically arranged in a flat form at the same plane, so that the respective recursive reflectors can be arranged in a two-dimensional space with different elevation angles. This can achieve a similar effect.

Recursive reflectors which reflect, in incident directions, red, green and blue wavelength components of the incident light beams are arranged with different elevation angles, respectively, and, in the light projecting means, red, green and blue filters are successively arranged on the light path of the white light source with a predetermined time interval for successively projecting red, green and blue light beams to the observation target portion with a predetermined time interval. The image of the reflected light is received by a monochromatic TV camera. A color image signal producing circuit produces color image signals by combining the respective monochromatic image signals produced by the monochromatic TV camera. Thereby, a color image of the observation target portion can be obtained without a color TV camera, so that the cost can be reduced.

The color filters may be eliminated, and the white light source of the light projecting means may be replaced with a structure which includes a trichromatic light source successively projecting red, green and blue light beams with a predetermined time interval and a controller controlling the color of light beams emitted from the trichromatic light source. This can also achieve a similar effect.

Without using a plurality of recursive reflectors, a single recursive reflector may be arranged movably in a direction perpendicular to a reference surface so that the white light source may project white light beams to the recursive reflector at different levels. This can also achieve a similar effect.

By inspecting the observation target portion for a defect using the received light data, it is possible to reduce a cost of the apparatus in the inspection stage, improve the maintenance properties and simplify the adjusting work. Further, precise inspection can be conducted.

### BRIEF DESCRIPTION OF THE DRAWINGS

Fig. 1 shows a structure of an embodiment 1 of the invention.

Fig. 2 shows a recursive reflector having wavelength characteristics in the invention, wherein (a) shows a recursive reflector formed of corner cubes, (b) shows a recursive reflector formed of cat's eyes, and (c) is an elevation of the corner cube shown at (a).

Fig. 3 shows an example of a color image of an observation target portion in an embodiment 1 of the invention.

Fig. 4 shows a structure in which a white light source is arranged above a beam splitter in the embodiment 1 of the invention.

Fig. 5 shows a recursive reflector having wavelength characteristics using color filters in the invention, wherein (a) shows a recursive reflector using color filters and corner cubes, and (b) shows a recursive reflector using color filters and cat's eyes.

Fig. 6 shows a structure of light projecting means provided with a spherical reflector in the embodiment 1 of the invention.

Fig. 7 shows a structure of an embodiment 2 of the invention.

Fig. 8 shows a structure of light projecting means using a non-annular white light source in the embodiment 2 of the invention.

Fig. 9 shows a structure of an embodiment 3 of the invention.

Fig. 10 shows an example of a color image of an observation target portion in the embodiment 3 of the invention.

Fig. 11 shows an example of a monochromatic image of an observation target object produced with a monochromatic camera in the embodiment 3 of the invention.

Fig. 12 shows a structure of an embodiment 4 of the invention.

Fig. 13 shows a structure of an embodiment 5 of the invention.

Fig. 14 shows a structure of light receiving means employed together with a filter plate arranged on a light receiving axis in the embodiment 5 of the invention.

Fig. 15 shows a structure of light projecting means employed together with a trichromatic light source in the embodiment 5 of the invention.

Fig. 16 shows a structure of an embodiment 6 of the invention.

Fig. 17 shows a structure of an embodiment 7 of the invention.

Fig. 18 shows a structure of light projecting means in a conventional object observing apparatus.

### PREFERRED EMBODIMENTS FOR IMPLEMENTING THE INVENTION

### (Embodiment 1)

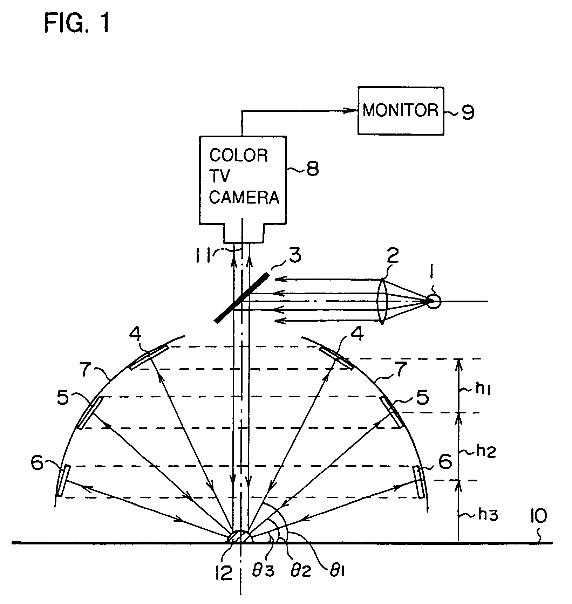

Fig. 1 shows a structure of an object observing apparatus of an embodiment 1 according to the invention. In Fig. 1, a reference number 1 indicates a white light source such as an incandescent lamp or a xenon lamp. 2 indicates a lens which changes white light beams radiated from white light source 1 into parallel beams. 3 indicates a beam splitter such as a half mirror, which reflects a portion of the parallel white light beams coming from lens 2 to an observation target portion 12, i.e., a portion to be observed, and also passes therethrough a portion of light beams reflected by recursive reflector 4, 5 or 6 and observation target portion 12. White light source 1, lens 2 and beam splitter 3 form light projecting means.

4 indicates an annular red recursive reflector which reflects, in an incident direction, a red wavelength component of the incoming white light beams reflected by observation target portion 12. 5 indicates a green recursive reflector which reflects, in an incident direction, a green wavelength component of the incoming white light beams reflected by observation target portion 12. 6 indicates a blue recursive reflector which reflects, in an incident direction, a blue wavelength component of the incoming white light beams reflected by observation target portion 12.

These red, green and blue recursive reflectors 4, 5 and 6 are different from each other in either one or both of radius of annular body and height from a reference surface 10, and thereby are arranged forming different elevation angles at observation target portion 12 located at a crossing point between reference surface 10 and a light receiving axis 11 of a color TV camera 8.

Each of recursive reflectors 4-6 is formed of minute corner cubes or glass beads forming cat's eyes which are arranged in a plane form, and therefore is basically equivalent to those provided at guard rails of roads.

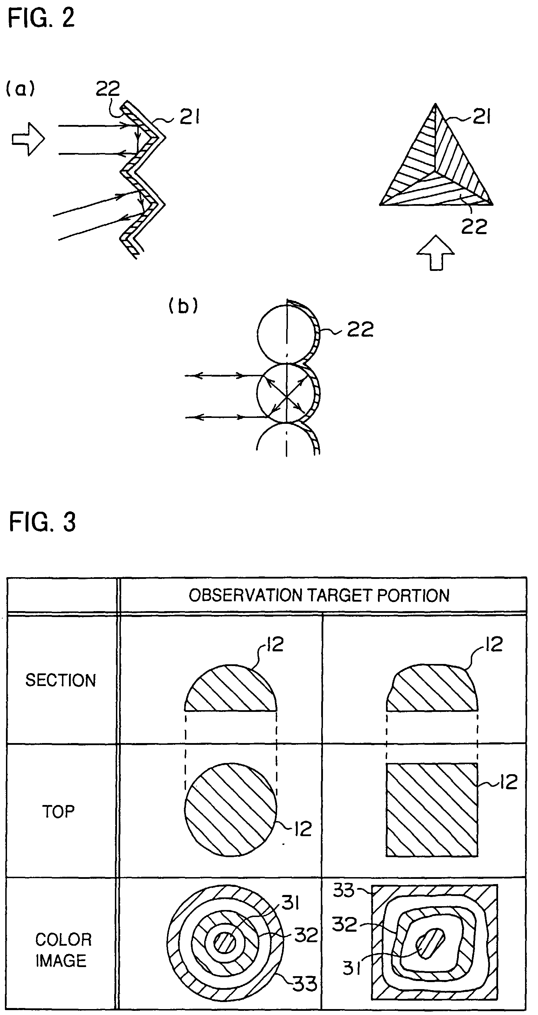

Fig. 2 shows the recursive reflector. More specifically, Fig. 2 shows at (a) the recursive reflector formed of corner cubes, and shows at (b) the recursive reflector formed of cat's eyes. At (c), it shows an elevation of the corner cube viewed in a direction of an arrow at (a).

At (a) in Fig. 2, corner cubes 21 are provided at their inner surfaces with a specific wavelength reflecting layer 22 which is applied or vapor-deposited thereto and allows pass of only a specific wavelength component of incoming light beams. Corner cubes 21 reflect only the specific wavelength component of incoming light beams. At (b) in Fig. 2, specific wavelength reflecting layer 22 is applied or vapor-deposited to hemispherical surfaces of cat's eyes 23.

Specific wavelength reflecting layer 22 passes only the red wavelength component of incoming light beams, and absorbs the other wavelength components. As shown in the figure, therefore, corner cubes 21 and cat's eyes 23 reflect the specific wavelength components of the incoming light beams in incident directions, i.e., in the same directions as the incident direction.

Corner cubes 21 shown at (a) in Fig. 21 allow only the specific wavelength to pass through specific wavelength reflecting layer 22, and absorb the other wavelengths. Further, light beams passed through specific wavelength reflecting layer 22 are reflected by the reflecting surface (inner surface) of corner cubes 21. Alternatively, corner cubes 21 may be formed of an optical multilayer film, which directly reflects only a specific wavelength and passes the other wavelengths, and a light absorbing member which absorbs light beams passed through this optical multilayer film. The latter can provide a higher reflectivity than the former. Cat's eyes 23 may be provided with colored hemispherical members so as to pass only a specific wavelength component and absorb the other wavelength components.

Referring to Fig. 1 again, 7 indicates a doom-shaped hood to which red, green and blue recursive reflectors 4, 5 and 6 are fixed. Hood 7 is preferably provided at its inner surface with a light absorbing structure such as a black coating for preventing reflection of light beams. Red, green and blue recursive reflectors 4, 5 and 6 as well as hood 7 form recursive reflecting means.

8 indicates a color TV camera forming an image from a reflected optical image, which is reflected by observation target portion 12 through red, green or blue recursive reflector 4, 5 or 6 and is received through beam splitter 3, and thereby issuing color image signals. 9 indicates a monitor displaying the color image. Color TV camera 8 and monitor 9 form light receiving means.

An operation of the embodiment 1 will be described below. White light beams radiated from white light source 1 are changed into parallel light beams by lens 2. A partial amount, e.g., a half amount of the parallel light beams are reflected by beam splitter 3, and are projected downward to observation target portion 12 through a predetermined light path. The white light beams projected through beam splitter 3 are reflected by respective curved surface elements of observation target portion 12 in directions corresponding to inclinations of the respective curved surface elements with respect to reference surface 10. White light beams reflected in the direction of an elevation angle θ₁ reach red recursive reflector 4. White light beams reflected in the direction of an elevation angle θ₂ reach green recursive reflector 5. White light beams reflected in the direction of an elevation angle θ₃ reach blue recursive reflector 5.

As described above, since each of recursive reflectors 4-6 reflect only the specific wavelength components in the incident directions, respectively, the red, green and blue light beams are reflected by red, green and blue recursive reflectors 4, 5 and 6 in the incident directions, returns through their incoming paths, respectively, and then are reflected by observation target portion 12 in the direction along light receiving axis 11.

The reflected red, green and blue light beams reach beam splitter 3 through the same light path as the projection path. A partial amount, e.g., a half amount of the light beams travel through beam splitter 3 and reach TV camera 8.

Color TV camera 8 forms a color image from the reflected optical image including the red, green and blue light beams, and thereby issues color image signals to monitor 9, which displays the produced color image. In the color image of the reflected optical image displayed on monitor 9, if observation target portion 12 is a mirror reflection portion, portions corresponding to elevation angles θ₁, θ₂ and θ₃ of curved surface elements to be described below are colored red, green and blue, so that observation target portion 12 is colored red, green or blue correspondingly to the three-dimensional configuration thereof.

If observation target portion 12 is an irregular reflection portion, the surface color of observation target portion 12 is imaged by color TV camera 8, so that the surface color can be observed.

Fig. 3 shows an example of a color image in the case where observation target portion 12 is a mirror reflection portion. 31 indicates a red-colored portion, 32 indicates a green-colored portion and 33 indicates a blue-colored portion. Portions which are irregular reflection portions are colored in colors thereof in the color image, respectively.

According to the embodiment 1 of the invention, the light source can be formed of a single light source owing to provision of the plurality of recursive reflectors which reflect different specific wavelengths in the incident directions, respectively. Therefore, the cost can be reduced, and the maintenance properties can be improved. Further, adjustment of several color light sources for producing white light beams is not required, so that a work for adjustment of the light source can be simplified.

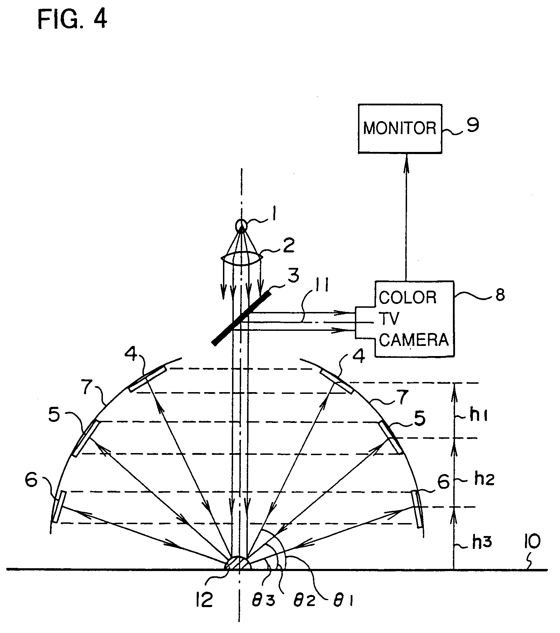

As shown in Fig. 4, white light source 1 and lens 2 may be arranged above beam splitter 3, and color TV camera 8 may be arranged horizontally with respect to beam splitter 3.

Although the recursive reflectors reflect the wavelength components of red, green and blue, they may naturally be adapted to reflect light beams of other colors. In contrast to the prior art, it is not necessary that the components of these colors provide white light beams when mixed.

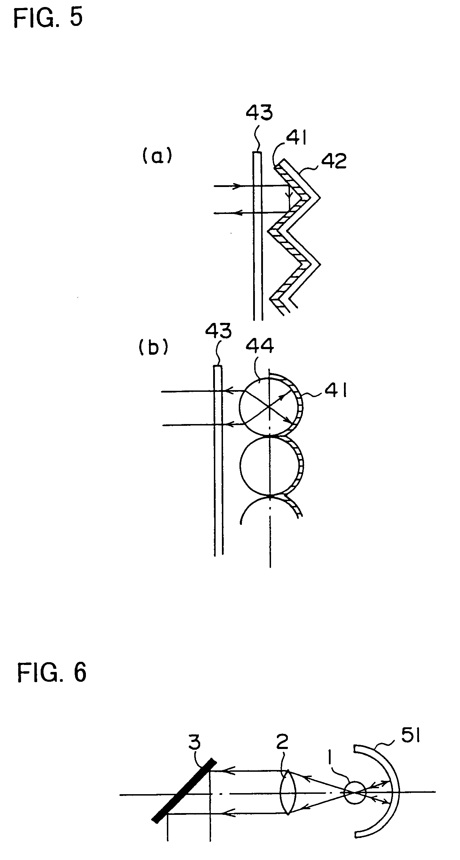

As shown at (a) in Fig. 5, corner cubes 42 may be provided at their inner surfaces with a total reflection layer 41 such as silver foil applied or vapor-deposited thereto, and a color filter 43 allowing passage of incident light beams of a specific wavelength component may be arranged at the front side of corner cubes 42, so that the recursive reflector reflecting a specific wavelength may be formed of corner cubes 42 and color filter 43. As shown at (b) in Fig. 5, color filter 43 may be arranged at the front side of cat's eyes 44 which are provided at their hemispherical surfaces with total reflection layer 41 such as silver foil vapor-deposited or applied thereto, so that cat's eyes 44 and color filter 43 may form the recursive reflector.

As shown in Fig. 6, a spherical reflector 51 reflecting the white light beams radiated from white light source 1 may be arranged at a position opposed to lens 2 with white light source 1 therebetween, in which case a utilization efficiency of white light source 1 can be substantially doubled.

In the observation target portion including a portion having mirror reflection characteristics, if it is required to determine only schematically a configuration and a position of the mirror reflection portion, the apparatus may not include the plurality of recursive reflectors at different elevation angles. Alternatively, if the observation target portion does not include, e.g., a green irregular reflection portion, only green recursive reflector 5 may be employed. The object observing apparatus thus formed can further reduce the cost.

In the observation target portion including a portion having mirror reflection characteristics, if it is required to determine only schematically a configuration and a position of the mirror reflection portion, and a color image of the periphery is not required, a monochromatic TV camera may be used instead of color TV camera 8. Recursive reflectors 4-6 having wavelength properties may be replaced with recursive reflectors, which do not have wavelength characteristics and reflect the entire wavelength components of incident light beams in the incident directions. In this case, red, green and blue portions 31, 32 and 33 shown in Fig. 3 are observed as portions having higher brightness than the peripheries in a monochromatic gray-scale image.

In the object observing apparatus thus constructed, the cost can be further reduced by the use of a monochromatic TV camera.

### (Embodiment 2)

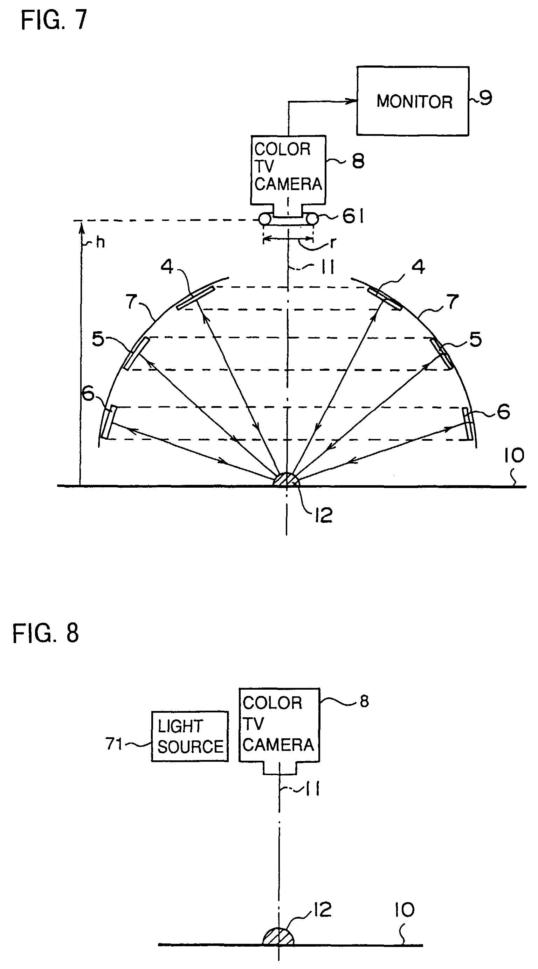

Fig. 7 shows an object observing apparatus of an embodiment 2 of the invention. The same parts and portions as those in Fig. 1 bear the same reference numbers, and will not be described below. In Fig. 7, 61 indicates an annular white light source, which has a center on light receiving axis 11, and is made of a fluorescent lamp, an optical fiber or the like disposed near light receiving axis 11.

Annular white light source 61 has a diameter r which much smaller than a height h from reference surface 10, whereby the optical axes with respect to observation target portion 12 can be deemed parallel to light receiving axis 11. This approximation is reasonable in view of the facts that the reflection directions of the recursive reflector is not completely coincident with the incident directions and are within a certain range, and that an object having the mirror reflection characteristics actually provides the reflection directions in a certain range due to partial diffuse reflection.

An operation of the embodiment 2 will be described below. White light beams radiated from annular white light source 61 are projected substantially downward to observation target portion 12. If observation target portion 12 is, for example, a soldered portion or the like having mirror reflection characteristics, the projected white light beams are directly reflected by respective curved surface elements of observation target portion 12 in directions depending on inclinations of the curved surface elements with respect to the reference surface.

The white light beams reflected toward recursive reflectors 4-6 reach recursive reflectors 4-6. Red recursive reflector 4 reflects the red light beams in the incident direction. Likewise, green and blue recursive reflectors 5 and 6 reflect the green and blue light beams in the incident directions, respectively. The light beams thus reflected return through the same paths, are reflected along light receiving axis 11 by observation target portion 12, and are received by color TV camera 8.

According to the embodiment 2, as described above, a beam splitter is not required owing to the structure in which annular white light source 61 concentrical with light receiving axis 11 is arranged near light receiving axis 11. Therefore, color TV camera 8, i.e., light receiving means can receive a larger amount of light than the embodiment 1, so that the cost can be reduced and the maintenance properties can be improved.

In the embodiment 2, as shown in Fig. 8, a non-annular white light source 71 may be arranged near light receiving axis 11 to provide the light projecting means.

### (Embodiment 3)

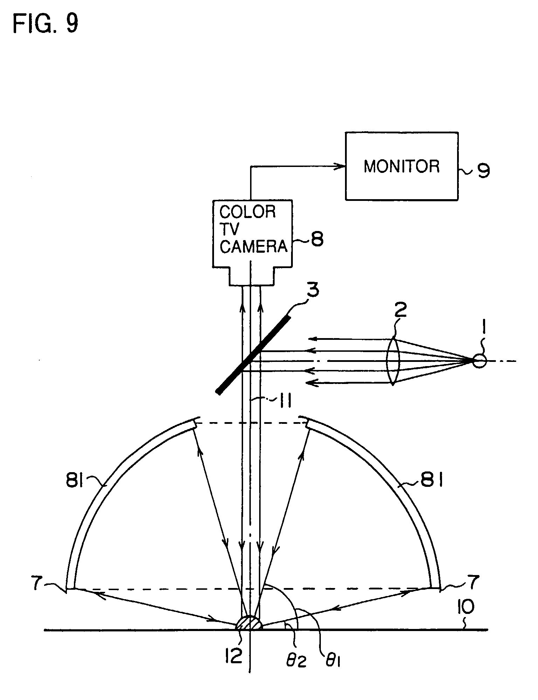

Fig. 9 shows a structure of an object observing apparatus of an embodiment 3 of the invention. The same parts and portions as those in Fig. 1 bear the same reference numbers, and will not be described below. In Fig. 9, 81 indicates a doom-shaped recursive reflector which reflects, in incident directions, specific wavelength components of incoming white light beams reflected by observation target portion 12 having the mirror reflection characteristics. The wavelength component reflected thereby continuously changes in accordance with an elevation angle at observation target portion 12.

For example, a region of the elevation angle of θ₁ reflects red wavelength component in the incident direction. As the elevation angle decreases, the reflected wavelength component continuously changes into yellow, green, ···. A region of the elevation angle θ₂ reflects only the purple wavelength component.

An operation of the embodiment 3 will be described below. The white light beams projected to observation target portion 12 through beam splitter 3 are reflected by the curved surface elements of observation target portion 12 in the directions depending on the inclinations of the curved surface elements, respectively.

The white light beams reflected in the direction of the elevation angle between θ₂ and θ₁ return to recursive reflector 81. At regions of different elevation angles in recursive reflector 81, only the specific wavelength components corresponding to the elevation angles are reflected in the incident directions, respectively. The color light beams from red to purple thus reflected return through the same paths, and are reflected by observation target portion 12 in the direction of light receiving axis 11.

In the color image of the reflected light image which is formed by color TV camera 8 and displayed on monitor 9, the respective curved surface elements of observation target portion 12 are colored in colors corresponding to the inclinations with respect to the reference surface. Therefore, observation target portion 12 is continuously colored in color which changes in accordance with the three-dimensional configuration of the portion 12.

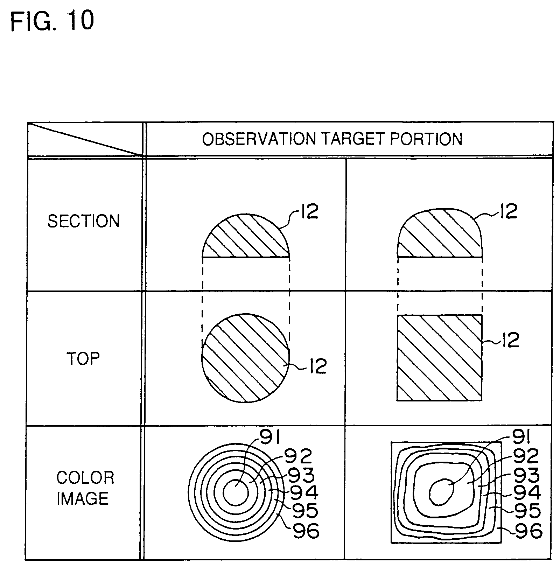

Fig. 10 shows an example of the color image thus produced. 91 indicates a red-colored portion, 92 indicates a yellow-colored portion, 93 indicates a green-colored portion, 94 indicates a cyan-colored portion, 95 indicates a blue-colored portion, and 96 indicates a purple-colored portion. As shown therein, observation target portion 12 is colored in color which continuously changes between red and purple in accordance with the three-dimensional configuration.

According to the object observing apparatus of the embodiment 3, as described above, the recursive reflecting means is formed of doom-shaped recursive reflector 81, which reflects, in the incident direction, the specific wavelength component of the incoming white light beams, and the wavelength component reflected thereby continuously changes in accordance with the elevation angle at observation target portion 12. Further, in the color image, observation target portion 12 is continuously colored in color which changes in accordance with the three-dimensional configuration. Therefore, the observation can be performed more precisely.

In the embodiment 3 processing the observation target portion which includes a portion having mirror reflection characteristics, it may be required to determine only the two-dimensional configuration and the position of the mirror reflection portion, and the color image around the mirror reflection portion may not be not required, for example, in such a case that a waterdrop on the observation target object is to be observed. In this case, color TV camera 8 may be replaced with a monochromatic TV camera, and recursive reflector 81 having wavelength properties may be replaced with a recursive reflector which does not have wavelength properties and reflects in the incident directions the entire wavelength components of incident light beams.

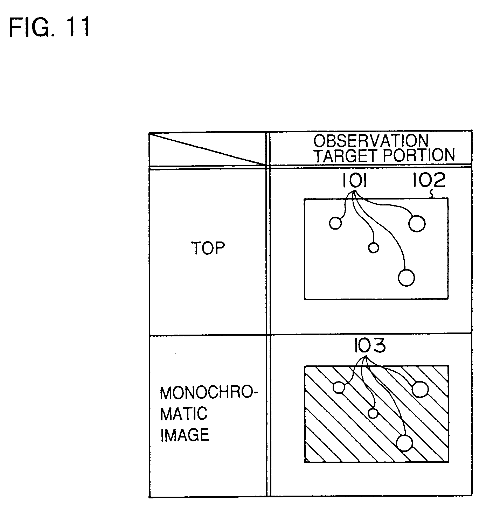

Fig. 11 shows an example of a monochromatic image formed by such an object observing apparatus. 101 indicates mirror reflection portions on an observation target object 102, 103 indicates portions having a higher brightness than its periphery in a monochromatic image and thus corresponding to mirror reflection portions 101. This object observing apparatus can employ a monochromatic TV camera to reduce the cost.

### (Embodiment 4)

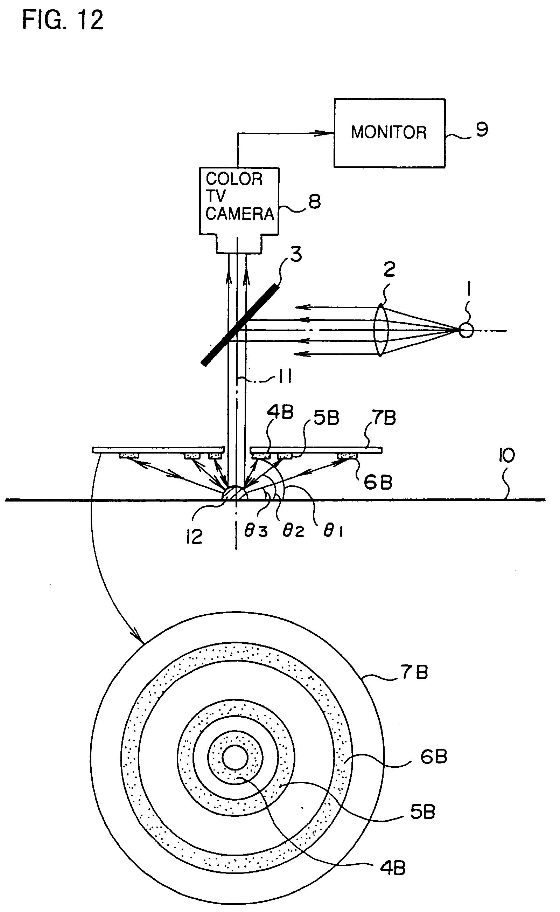

Fig. 12 shows a structure of an embodiment 4 of an object observing apparatus of the invention. The same parts and portions as those in Fig. 1 bear the same reference numbers, and will not be described below. In Fig. 12, 4B indicates a red recursive reflector which reflects, in the incident direction, the red wavelength component of the incident white light beams reflected by observation target portion 12. 5B indicates a green recursive reflector which reflects, in the incident direction, the green wavelength component of the incident white light beams reflected by observation target portion 12. 6B indicates a blue recursive reflector which reflects, in the incident direction, the blue wavelength component of the incident white light beams reflected by observation target portion 12.

These red, green and blue recursive reflectors 4B, 5B and 6B are arranged at the same plane on a lower surface of a circular plate 7B and are concentrical with each other. Thereby, red, green and blue recursive reflector 4B, 5B and 6B are located at the same height or level from reference surface 10, but have different radii, so that they form different elevation angles θ₁, θ₂ and θ₃ at observation target portion 12 located at the crossing between reference surface 10 and light receiving axis 11 of color TV camera 8.

An operation of the embodiment 4 will be described below. The white light beams radiated from white light source 1 are changed by lens 2 into parallel light beams, are partially reflected by beam splitter 3 and are projected substantially downward to observation target portion 12. The curved surface elements of observation target portion 12 directly reflect the projected white light beams in the directions depending on the inclinations of the curved surface elements with respect to reference surface 10, respectively.

The white light beams reflected in the directions toward recursive reflectors 4B-6B reach recursive reflectors 4B-6B, respectively, so that the red, green and blue light beams are reflected in the incident directions by the red, green and blue recursive reflectors 4B, 5B and 6B, and return through the same paths, respectively. The light beams thus returned are reflected in the direction of light receiving axis 11 by observation target portion 12, and are received by color TV camera 8.

According to the embodiment 4, as described above, recursive reflectors 4B-6B are arranged at the same plane to form the two-dimensional configuration. Therefore, the structure can be manufactured more simply than that of the embodiment 1.

### (Embodiment 5)

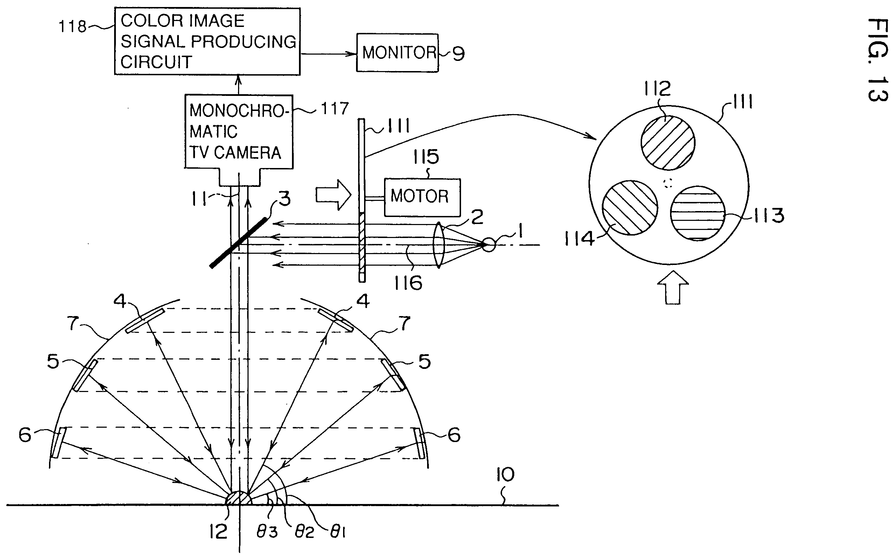

Fig. 13 shows a structure of an object observing apparatus of an embodiment 5 of the invention. The same parts and portions as those in Fig. 1 bear the same reference numbers, and will not be described below. In Fig. 13, 111 indicates a filter plate 111 having a red filter 112, a green filter 113 and a blue filter 114. 115 indicates a drive motor which drives and rotates filter plate 11.

Drive motor 115 intermittently rotates filter plate 111 with a predetermined time interval, so that red, green and blue filters 112, 113 and 114 are successively located at a light path 116 between white light source 1 and lens 2 with a predetermined time interval, and thereby red, green and blue light beams are successively projected to observation target portion 12 through lens 2 and beam splitter 3 with a predetermined time interval.

117 indicates a monochromatic TV camera which issues monochromatic image signals by capturing the reflected optical image reflected by red, green and blue recursive reflectors 4, 5 and 6 and observation target portion 12 and passed through beam splitter 3.

118 indicates a color image signal producing circuit, which has a frame memory and others, and produces color image signals by combining the monochromatic image signals produced by monochromatic TV camera 117 with color filters 112, 113 and 114.

An operation of the embodiment 5 will be described below. When red filter 112 is disposed at light path 116, the red light beams produced by red filter 112 are changed into parallel light beams by lens 2, and a partial amount, e.g., a half amount of the light beams are reflected by beam splitter 3 and are projected downward by observation target portion 12. The beams thus projected are reflected by the respective curved surface elements of observation target portion 12 in the directions depending on the inclinations of the curved surface elements with respect to the reference surface. The red light beams reflected in the direction of the elevation angle θ₁ reach red recursive reflector 4, and are reflected in the incident direction to return through the same path. Then, the light beams are reflected in the direction of light receiving axis 11 by observation target portion 12.

Meanwhile, the red light beams reflected in the direction of the elevation angle θ₂ reach green recursive reflector 5, and the red light beams reflected in the direction of the elevation angle θ₃ reach blue recursive reflector 6. However, these light beams are not reflected owing to the wavelength characteristics of the green and blue recursive reflectors 5 and 6.

Therefore, only the red light beams reflected by red recursive reflector 4 reach beam splitter 3, and a partial amount, e.g., a half amount of the light beams pass through beam splitter 3 and are received by monochromatic camera 117.

Likewise, when green filter 113 is disposed at light path 116, only the green light beams reflected by green recursive reflector 5 reach beam splitter 3, and are received by monochromatic TV camera 117. When blue filter 114 is disposed at light path 116, only the blue light beams reflected by blue recursive reflector 6 reach beam splitter 3, and are received by monochromatic TV camera 117.

Color image signal producing circuit 118 produces color image signals, of which R-, G- and B-signal levels are determined by levels of monochromatic image signals produced by monochromatic TV camera 117 when red, green and blue light beams are projected, respectively. The color image signals produced by color image signal producing circuit 118 are supplied to monitor 9, so that monitor 9 displays a color image of observation target portion 12 as shown in Fig. 3.

The light beams projected to the top of observation target portion 12 from white light source 1 are reflected in the direction of light receiving axis 11 and are received by monochromatic TV camera 117. Therefore, a region from which all the projected light beams are commonly received is ignored.

According to the embodiment 5, as described above, there is arranged filter plate 111 having red, green and blue filters 112, 113 and 114, and red, green and blue filters 112, 113 and 114 are successively disposed at light path 116, so that red, green and blue light beams are successively projected to observation target portion 12 with a predetermined time interval. The respective reflected optical images are received by monochromatic TV camera 117, and color image signal producing circuit 118 combines the respective monochromatic image signals issued from monochromatic TV camera 117 to produce the color image signals. Thereby, the color image of observation target portion 12 can be produced without a color TV camera. Therefore, the cost can be reduced.

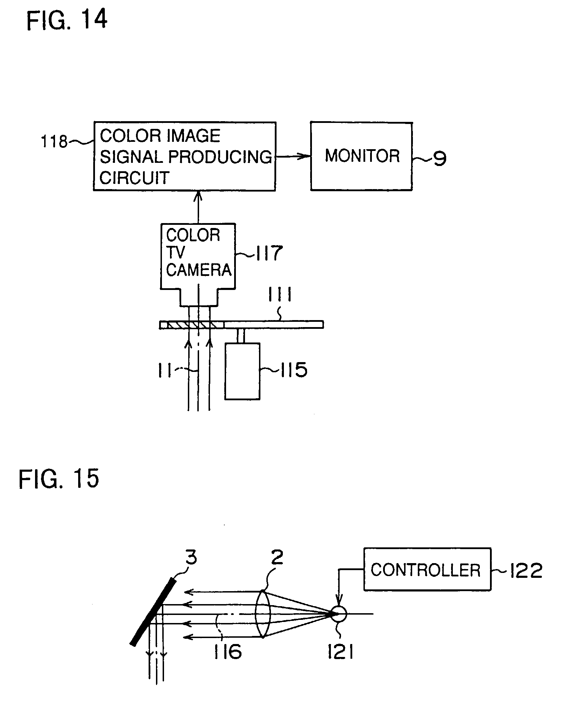

In the embodiment 5, as shown in Fig. 14, filter plate 111 may be arranged on light receiving axis 11 of monochromatic TV camera 117. Instead of filter plate 111 and motor 115, such a mechanism may be employed that successively disposes red, green and blue filters in a manner similar to a conventional slide projector.

Without using filter plate 111, white light source 1 forming the light projecting means may be replaced with a trichromatic light source 121, which successively radiates red, green and blue light beams with a predetermined time interval, and a controller 122 controlling the colors of light beams radiated from trichromatic light source 121.

### (Embodiment 6)

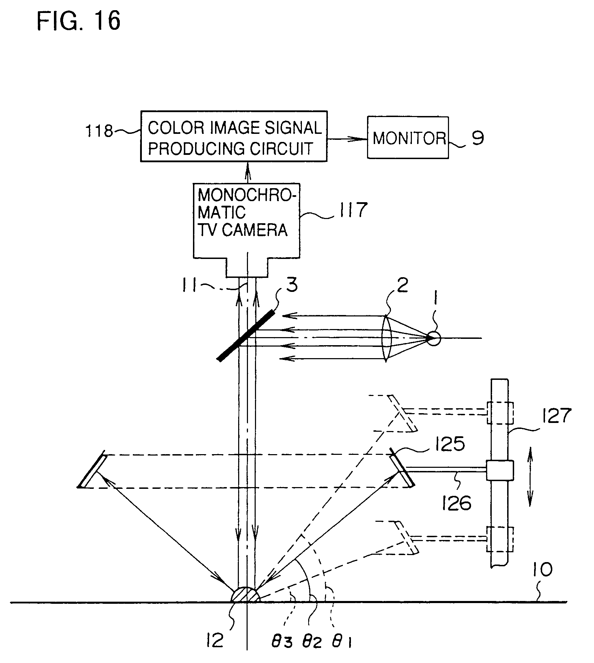

Fig. 16 shows a structure of an object observing apparatus of an embodiment 6 of the invention. The same parts and portions as those in Fig. 13 bear the same reference numbers, and will not be described below.

In Fig. 16, 125 indicates an annular recursive reflector which reflects, in the incident direction, the entire wavelength components of incident light beams reflected by observation target portion 12. 126 indicates a carrier bar holding recursive reflector 126 parallel to reference surface 10. 127 indicates a movable rod for vertically moving carrier bar 126. Movable rod 127 is driven by a drive unit (not shown) perpendicularly to reference surface 10 to move recursive reflector 125 to upper, middle and lower positions.

An operation of the embodiment 6 will be described below. The white light beams including all the wavelength components radiated from white light source 1 are changed into parallel light beams by lens 2, are partially reflected by beam splitter 3 and are projected downward to observation target portion 12. The light beams thus projected are reflected by the respective curved surface elements of observation target portion 12 in the directions depending on the inclinations of the respective curved surface elements with respect to the reference surface.

It is now assumed that recursive reflector 125 is located at the middle position forming the elevation angle of θ₂. In this case, only the white light beams reflected in the direction of the elevation angle θ₂ reach recursive reflector 125, and are reflected in the incident direction, so that the light beams return through the same path, and are reflected at observation target portion 12 in the direction of light receiving axis 11. A partial amount, e.g., a half amount of the light beams pass through beam splitter 3, and are received by monochromatic TV camera 117.

Likewise, when recursive reflector 125 moves to the upper position forming the elevation angle of θ₁, only the white light beams reflected in the direction of the elevation angle θ₁ reach recursive reflector 125, and are reflected in the incident direction to return through the same path. Then, the light beams are reflected at observation target portion 12 in the direction of light receiving axis 11, travel through beam splitter 3, and are received by monochromatic TV camera 117.

When recursive reflector 125 moves to the lower position at the elevation angle of θ₃, only the white light beams reflected in the direction of the elevation angle θ₃ reach recursive reflector 125, and are reflected in the incident direction to return through the same path. Then, the light beams are reflected at observation target portion 12 in the direction of light receiving axis 11, travel through beam splitter 3, and are received by monochromatic TV camera 117.

Color image signal producing circuit 118 produces color image signals, of which R-, G- and B-signal levels are determined by levels of monochromatic image signals produced by monochromatic TV camera 117 with recursive reflector 125 at different positions, respectively. The color image signals produced by color image signal producing circuit 118 are supplied to monitor 9, so that monitor 9 displays a color image of observation target portion 12 as shown in Fig. 3.

The light beams projected to the top of observation target portion 12 from white light source 1 are reflected in the direction of light receiving axis 11 and are received by monochromatic TV camera 117. Therefore, a region from which all the projected light beams are commonly received is ignored.

According to the embodiment 6, the white light beams are projected to observation target portion 12, and the reflected optical image formed depending on the levels of recursive reflector 125 is received by monochromatic TV camera 117. Color image signal producing circuit 118 combines the respective monochromatic image signals issued from monochromatic TV camera 117 to produce the color image signals, whereby the color image of observation target portion 12 can be produced without using a color TV camera and a filter plate. Therefore, the cost can be reduced.

In the embodiment 6, the vertical position of recursive reflector 125 may be continuously changed, and thereby the respective curved surface elements of observation target portion 12 are colored in colors corresponding to the inclinations with respect to the reference surface. Thereby, coloring in color which continuously changes depending on the three-dimensional configuration of observation target portion 12 can be achieved as shown in Fig. 10.

### (Embodiment 7)

Fig. 17 shows a structure of an object observing apparatus of an embodiment 7 of the invention, and in particular shows an example of inspection of part mounted portions on a part mounted board. In this embodiment, inspection of observation target portions for defects is performed with received light data obtained from one of the object observing apparatuses of the embodiments 1 to 6.

In Fig. 17, 131 shows a movable unit which carries a part mounted board 137 and is movable in XY-directions to locate successively part mounted portions 138 at the position on light receiving axis 11. 132 indicates an object observing apparatus which is the same as those of the embodiments 1 to 6, and produces the color image signals of the observation target portion, i.e., part mounted portion 138.

133 indicates an image processing unit which performs A/D conversion on the color image signals issued from object observing apparatus 132, and effects various kinds of image processing on the obtained digital color image data. 134 indicates a determining unit determining acceptance or non-acceptance of part mounted board 137 based on a shape, an area and a length of a pattern of processed image data obtained at image processing unit 133 as well as an image difference between R-, G- and B-images. 135 indicates a storage unit which stores digital color image data and processed image data produced by image processing unit 133 as well as results of determination of acceptance/non-acceptance of part mount portions 138 by determining unit 134.

136 indicates a control unit which controls movable unit 131, object observing apparatus 132, image processing unit 133, determining unit 134 and storage unit 135. Movable unit 131 and control unit 136 form movable means. Image processing unit 133, determining unit 134, storage unit 135 and control unit 136 form inspection conducting means.

An operation of the embodiment 7 will be described below. Control unit 136 moves movable unit 131 to locate part mounted portion 138 at the position on light receiving axis 11 of object observing apparatus 132, and operates object observing apparatus 132 to form an image of part mounted portion 138 and thereby produce color image signals. The color image signals are sent to image processing unit 133.

Then, control unit 136 operates image processing unit 133, and converts the color image signals of part mounted portion 138, which are supplied from object observing apparatus 132, into digital color image data by A/D conversion. Further, image processing unit 133 effects various kinds of image processing on the digital image data for determining acceptance/non-acceptance of part mounted portion 138. The processed image data is set to determining unit 134.

Then, control unit 136 operates determining unit 134 to determine acceptance/non-acceptance of the quantity, shape, position and others of solder at part mounted portion 138 based on the processed image data issued from image processing unit 133. The results of this determination are stored in storage unit 135, whereby inspection of part mounted portion 138 is completed.

In this manner, control unit 136 operates movable unit 131 to locate successively part mounted portions 138 on part mounted board 137 at light receiving axis 11 for the above inspection of part mounted portions 138.

According to the embodiment 7, as described above, determination or inspection of the observation target portions for defects is conducted with the received light data obtained by the same object observing apparatus as those of the embodiments 1 to 6, whereby the apparatus cost in the inspection stage can be reduced, the maintenance properties thereof are improved, and the adjusting work can be simplified. Also, the accuracy in the inspection can be improved.

### INDUSTRIAL APPLICABILITY

According to the invention, as described above, a plurality of recursive reflectors which reflect, in the incident directions, different specific wavelengths, respectively, are used, whereby the light source can be the single light source. Therefore, it is possible to reduce the cost and improve the maintenance properties of the apparatus and method of observing the object, which includes a portion having mirror reflection properties.

## Claims

1. An object observing apparatus comprising:
light projecting means for projecting light beams through a predetermined light path to an observation target portion of an object;
recursive reflecting means for reflecting in an incident direction said incoming light beams reflected by said observation target portion; and
light receiving means for receiving said light beams reflected by said recursive reflecting means and said observation target portion and coming through said predetermined light path.

2. The object observing apparatus according to claim 1, wherein said recursive reflecting means is arranged annularly with respect to a center of said observation target portion.

3. The object observing apparatus according to claim 1, wherein said recursive reflecting means is arranged in a doom-like form with respect to a center of said observation target portion.

4. The object observing apparatus according to claim 1, wherein said recursive reflecting means are plural in number and are arranged at positions forming different elevation angles at a center of said observation target portion.

5. The object observing apparatus according to claim 1, wherein said recursive reflecting means are plural in number and are arranged annularly at a plurality of positions with respect to a center of said observation target portion respectively, said positions forming different elevation angles at a center of said observation target portion.

6. The object observing apparatus according to any one of preceding claims 1 to 5, wherein said recursive reflecting means reflects a specific wavelength of the light beams reflected by said observation target portion.

7. The object observing apparatus according to claim 1, 2 or 3, wherein said specific wavelength reflected by said recursive reflecting means continuously changes in accordance with the elevation angle at the center of said observation target portion.

8. The object observing apparatus according to claim 4 or 5, wherein said plurality of recursive reflecting means reflect said light beams of different specific wavelengths, respectively.

9. The object observing apparatus according to any one of preceding claims 1 to 5, wherein said light projecting means has a light source and a beam splitter for reflecting the light beams radiated from said light source to project the same to said observation target portion and passing the light beams reflected by said observation target portion therethrough to apply the same to said light receiving means.

10. The object observing apparatus according to any one of preceding claims 1 to 5, wherein said light projecting means has a light source arranged near a light receiving axis of said light receiving means and projecting the light beams to said observation target portion.

11. The object observing apparatus according to claim 10, wherein said light source of said light projecting means is an annular light source concentrical with the light receiving axis of said light receiving means.

12. An object observing apparatus comprising:
light projecting means for projecting white light beams emitted from a white light source to an observation target portion of an object through a predetermined light path;
a plurality of recursive reflecting means arranged annularly at positions forming different elevation angles at a center of said observation target portion for reflecting, in the incident directions, at least two color wavelength components of the incoming white light beams reflected by said observation target portion; and
light receiving means for distinguishing and receiving said at least two color wavelength components reflected by said recursive reflecting means and said observation target portion and coming through said predetermined light path.

13. An object observing apparatus comprising:
light projecting means for projecting white light beams emitted from a white light source to an observation target portion of an object through a predetermined light path;
a plurality of recursive reflecting means arranged annularly at positions forming different elevation angles at a center of said observation target portion for reflecting in incident directions a red wavelength component, a green wavelength component and a blue wavelength component of said incoming white light beams reflected by said observation target portion, respectively; and
light receiving means for distinguishing and receiving red, green and blue light beams reflected by said recursive reflecting means and said observation target portion and coming through said predetermined light path.

14. An object observing apparatus comprising:
light projecting means for projecting white light beams emitted from a white light source to an observation target portion of an object through a predetermined light path;
recursive reflecting means arranged in a doom-like form with respect to a center of said observation target portion for reflecting, in an incident direction, light beams of a specific wavelength of said incoming white light beams reflected by said observation target portion such that said specific wavelength continuously changes in accordance with the elevation angle at the center of said observation target portion; and
light receiving means for receiving light beams of said specific wavelength reflected by said recursive reflecting means and said observation target portion and coming through said predetermined light path.

15. An object observing apparatus comprising:
light projecting means for successively projecting light beams of at least two color wavelength components to an observation target portion of an object through a predetermined light path with a predetermined time interval;
at least two recursive reflecting means arranged at positions forming different elevation angles at a center of said observation target portion for reflecting in incident directions said light beams of said at least two incoming color wavelength components reflected by said observation target portion; and
light receiving means having a two-dimensional light receiving element successively receiving said at least two color wavelength components reflected by said recursive reflecting means and the observation target portion and coming through said predetermined light path.

16. An object observing apparatus comprising:
light projecting means for successively projecting red, green and blue light beams through a predetermined light path to an observation target portion of an object, said red, green and blue light beams being produced by passing, respectively, through red, green and blue filters successively arranged on a light projection axis of a white light source with a predetermined time interval;
a plurality of recursive reflecting means arranged at positions forming different elevation angles at a center of said observation target portion, for reflecting, in incident directions, said red, green and blue wavelength components of said incoming color light beams reflected by said observation target portion, respectively; and
light receiving means having a monochromatic TV camera successively receiving said color wavelength components reflected by said recursive reflecting means and said observation target portion and coming through said predetermined light path.

17. An object observing apparatus comprising:
light projecting means for projecting white light beams emitted from a white light source to an observation target portion of an object through a predetermined light path;
a plurality of recursive reflecting means arranged at positions forming different elevation angles at a center of said observation target portion for reflecting, in incident directions, red, green and blue wavelength components of said incoming white light beams reflected by said observation target portion, respectively; and
light receiving means successively receiving red, green and blue light beams passed, respectively, through red, green and blue filters successively arranged on a light receiving axis of a monochromatic TV camera with a predetermined time interval, said monochromatic TV camera receiving said light wavelength components reflected by said recursive reflecting means and said observation target portion and coming through said predetermined light path.

18. An object observing apparatus comprising:
light projecting means for successively projecting light beams emitted from a trichromatic light source to an observation target portion of an object through a predetermined path, said trichromatic light source being operable to change its light beams into red, green and blue with a predetermined time interval;
a plurality of recursive reflecting means arranged at positions forming different elevation angles at a center of said observation target portion for reflecting, in incident directions, red, green and blue wavelength components of said incoming color light beams reflected by said observation target portion, respectively; and
light receiving means having a monochromatic TV camera successively receiving said respective color wavelength components reflected by said recursive reflecting means and said observation target portion and coming through said predetermined light path.

19. An object observing apparatus comprising:
light projecting means for projecting light beams of at least two color wavelength components simultaneously or with a predetermined time interval to an observation target portion of an object through a predetermined light path;
at least two recursive reflecting means arranged at positions forming different elevation angles at a center of said observation target portion for reflecting, in incident directions, at least two incoming color wavelength components reflected by said observation target portion; and
light receiving means having a two-dimensional light receiving element successively receiving at least two color wavelength components reflected by said recursive reflecting means and said observation target portion and coming through said predetermined light path.

20. The object observing apparatus according to any one of preceding claims 1 to 5, further comprising
inspection conducting means for detecting a mirror reflection portion of said observation target portion based on data of the light received by said light receiving means, and inspecting said observation target portion for a defect based on a result of the detection.

21. A method of observing an object comprising the steps of:
projecting light beams from light projecting means through a predetermined light path to an observation target portion of an object;
reflecting, in an incident direction, the incoming light beams reflected by said observation target portion by recursive reflecting means; and
receiving by light receiving means said light beams reflected by said recursive reflecting means and said observation target portion and coming through said predetermined light path.

22. The method of observing the object according to claim 21, wherein the light beams reflected by said observation target portion are reflected in the incident direction by said recursive reflecting means arranged annularly with respect to a center of said observation target portion.

23. The method of observing the object according to claim 21, wherein the light beams reflected by said observation target portion are reflected in the incident direction by said recursive reflecting means arranged in a doom-like form with respect to a center of said observation target portion.

24. The method of observing the object according to claim 21, wherein the light beams reflected by said observation target portion are reflected in the incident directions by the plurality of recursive reflecting means located at positions forming different elevation angles at a center of said observation target portion, respectively.

25. The method of observing the object according to claim 21, wherein the light beams reflected by said observation target portion are reflected in the incident directions by the plurality of recursive reflecting means arranged annularly with respect to a center of said observation target portion and located at positions forming different elevation angles at the center of said observation target portion, respectively.

26. The method of observing the object according to any one of preceding claims 21 to 25, wherein said recursive reflecting means is operable to reflect the light beams of a specific wavelength reflected by said observation target portion, and reflects, in the incident direction, the specific wavelength component of the light beams reflected by said observation target portion.

27. The method of observing the object according to claim 21 or 23, wherein said recursive reflecting means is operable to change continuously a specific wavelength reflected thereby in accordance with the elevation angle at a center of said observation target portion, and reflects, in the incident direction, the wavelength component corresponding to said elevation angle of the light beams reflected by said observation target portion.

28. The method of observing the object according to claim 24 or 25, wherein said recursive reflecting means is operable to reflect specific wavelengths partially differing from each other, and reflects, in the incident direction, the specific wavelength components of the light beams reflected by said observation target portion.

29. A method of observing an object comprising the steps of:
projecting white light beams to an observation target portion of an object through a predetermined light path from light projecting means having a white light source;
reflecting, in incident directions, by a plurality of recursive reflecting means red, green and blue wavelength components of said incoming white light beams reflected by said observation target portion, respectively, said plurality of recursive reflecting means being arranged annularly at positions forming different elevation angles at a center of said observation target portion; and
receiving by light receiving means the red, green and blue light beams reflected by said recursive reflecting means and said observation target portion and coming through said predetermined light path.

30. A method of observing an object comprising the steps of:
projecting white light beams from light projecting means having a white light source to an observation target portion of an object through a predetermined light path;
reflecting, in an incident direction, light beams of a specific wavelength of said incoming white light beams reflected by said observation target portion by recursive reflecting means arranged in a doom-like form with respect to a center of said observation target portion, said specific wavelength being variable in accordance with an elevation angle at a center of said observation target portion; and
receiving the light beams of said specific wavelength reflected by said recursive reflecting means and said observation target portion and coming through said predetermined light path.

31. A method of observing an object comprising the steps of:
projecting light beams of at least two color wavelength components simultaneously or with a predetermined time interval from light projecting means to an observation target portion of an object through a predetermined light path;
reflecting said at least two incoming color wavelength components reflected at said observation target portion by at least two recursive reflecting means arranged at positions forming different elevation angles at a center of said observation target portion; and
successively receiving, by light receiving means having a two-dimensional light receiving element, said at least two color wavelength components reflected by said recursive reflecting means and said observation target portion and coming through said predetermined light path.

32. A method of observing an object comprising the steps of:
successively projecting light beams of at least two light wavelength components with a predetermined time interval to an observation target portion of an object from light projecting means through a predetermined light path;
reflecting, in incident directions, said at least two incoming color wavelength components reflected by said observation target portion by at least two recursive reflecting means arranged at positions forming different elevation angles at a center of said observation target portion; and
successively receiving by light receiving means having a two-dimensional light receiving element said at least two color wavelength components reflected by said recursive reflecting means and said observation target portion and coming through said predetermined light path.

33. The method Of observing the object according to any one of preceding claims 21 to 25 and 29 to 32, further comprising the steps of: detecting, by inspection conducting means, a mirror reflection portion of said observation target portion based on data of said light received by said light receiving means, and inspecting said observation target portion for a defect based on a result of said detection.

## Amended claims

### Amended claims under Art. 19.1 PCT

1. (Amended) An object observing apparatus comprising:
light projecting means for projecting light beams through a predetermined light path to an observation target portion of an object;
recursive reflecting means for reflecting in an incident direction said incoming light beams reflected by said observation target portion; and
light receiving means for receiving said light beams reflected by said recursive reflecting means and said observation target portion and coming through said predetermined light path, wherein
said recursive reflecting means are plural in number and are arranged at positions forming different elevation angles at a center of said observation target portion.
2. The object observing apparatus according to claim 1, wherein said recursive reflecting means is arranged annularly with respect to a center of said observation target portion.
3. The object observing apparatus according to claim 1, wherein said recursive reflecting means is arranged in a doom-like form with respect to a center of said observation target portion.
4. (Canceled)
5. The object observing apparatus according to claim 1, wherein said recursive reflecting means are plural in number and are arranged annularly at a plurality of positions with respect to a center of said observation target portion respectively, said positions forming different elevation angles at a center of said observation target portion.
6. (Amended) The object observing apparatus according to any one of preceding claims 1 to 3 and 5, wherein said recursive reflecting means reflects a specific wavelength of the light beams reflected by said observation target portion.
7. The object observing apparatus according to claim 1, 2 or 3, wherein said specific wavelength reflected by said recursive reflecting means continuously changes in accordance with the elevation angle at the center of said observation target portion.
8. (Amended) The object observing apparatus according to claim 5, wherein said plurality of recursive reflecting means reflect said light beams of different specific wavelengths, respectively.
9. (Amended) The object observing apparatus according to any one of preceding claims 1 to 3 and 5, wherein said light projecting means has a light source and a beam splitter for reflecting the light beams radiated from said light source to project the same to said observation target portion and passing the light beams reflected by said observation target portion therethrough to apply the same to said light receiving means.
10. (Amended) The object observing apparatus according to any one of preceding claims 1 to 3 and 5, wherein said light projecting means has a light source arranged near a light receiving axis of said light receiving means and projecting the light beams to said observation target portion.
11. The object observing apparatus according to claim 10, wherein said light source of said light projecting means is an annular light source concentrical with the light receiving axis of said light receiving means.
12. An object observing apparatus comprising:
light projecting means for projecting white light beams emitted from a white light source to an observation target portion of an object through a predetermined light path;
a plurality of recursive reflecting means arranged annularly at positions forming different elevation angles at a center of said observation target portion for reflecting, in the incident directions, at least two color wavelength components of the incoming white light beams reflected by said observation target portion; and
light receiving means for distinguishing and receiving said at least two color wavelength components reflected by said recursive reflecting means and said observation target portion and coming through said predetermined light path.
13. An object observing apparatus comprising:
light projecting means for projecting white light beams emitted from a white light source to an observation target portion of an object through a predetermined light path;
a plurality of recursive reflecting means arranged annularly at positions forming different elevation angles at a center of said observation target portion for reflecting in incident directions a red wavelength component, a green wavelength component and a blue wavelength component of said incoming white light beams reflected by said observation target portion, respectively; and
light receiving means for distinguishing and receiving red, green and blue light beams reflected by said recursive reflecting means and said observation target portion and coming through said predetermined light path.
14. An object observing apparatus comprising:
light projecting means for projecting white light beams emitted from a white light source to an observation target portion of an object through a predetermined light path;
recursive reflecting means arranged in a doom-like form with respect to a center of said observation target portion for reflecting, in an incident direction, light beams of a specific wavelength of said incoming white light beams reflected by said observation target portion such that said specific wavelength continuously changes in accordance with the elevation angle at the center of said observation target portion; and
light receiving means for receiving light beams of said specific wavelength reflected by said recursive reflecting means and said observation target portion and coming through said predetermined light path.
15. An object observing apparatus comprising:
light projecting means for successively projecting light beams of at least two color wavelength components to an observation target portion of an object through a predetermined light path with a predetermined time interval;
at least two recursive reflecting means arranged at positions forming different elevation angles at a center of said observation target portion for reflecting in incident directions said light beams of said at least two incoming color wavelength components reflected by said observation target portion; and
light receiving means having a two-dimensional light receiving element successively receiving said at least two color wavelength components reflected by said recursive reflecting means and the observation target portion and coming through said predetermined light path.
16. An object observing apparatus comprising:
light projecting means for successively projecting red, green and blue light beams through a predetermined light path to an observation target portion of an object, said red, green and blue light beams being produced by passing, respectively, through red, green and blue filters successively arranged on a light projection axis of a white light source with a predetermined time interval;
a plurality of recursive reflecting means arranged at positions forming different elevation angles at a center of said observation target portion, for reflecting, in incident directions, said red, green and blue wavelength components of said incoming color light beams reflected by said observation target portion, respectively; and
light receiving means having a monochromatic TV camera successively receiving said color wavelength components reflected by said recursive reflecting means and said observation target portion and coming through said predetermined light path.
17. An object observing apparatus comprising:
light projecting means for projecting white light beams emitted from a white light source to an observation target portion of an object through a predetermined light path;
a plurality of recursive reflecting means arranged at positions forming different elevation angles at a center of said observation target portion for reflecting, in incident directions, red, green and blue wavelength components of said incoming white light beams reflected by said observation target portion, respectively; and
light receiving means successively receiving red, green and blue light beams passed, respectively, through red, green and blue filters successively arranged on a light receiving axis of a monochromatic TV camera with a predetermined time interval, said monochromatic TV camera receiving said light wavelength components reflected by said recursive reflecting means and said observation target portion and coming through said predetermined light path.
18. An object observing apparatus comprising:
light projecting means for successively projecting light beams emitted from a trichromatic light source to an observation target portion of an object through a predetermined path, said trichromatic light source being operable to change its light beams into red, green and blue with a predetermined time interval;
a plurality of recursive reflecting means arranged at positions forming different elevation angles at a center of said observation target portion for reflecting, in incident directions, red, green and blue wavelength components of said incoming color light beams reflected by said observation target portion, respectively; and
light receiving means having a monochromatic TV camera successively receiving said respective color wavelength components reflected by said recursive reflecting means and said observation target portion and coming through said predetermined light path.
19. An object observing apparatus comprising:
light projecting means for projecting light beams of at least two color wavelength components simultaneously or with a predetermined time interval to an observation target portion of an object through a predetermined light path;
at least two recursive reflecting means arranged at positions forming different elevation angles at a center of said observation target portion for reflecting, in incident directions, at least two incoming color wavelength components reflected by said observation target portion; and
light receiving means having a two-dimensional light receiving element successively receiving at least two color wavelength components reflected by said recursive reflecting means and said observation target portion and coming through said predetermined light path.
20. (Amended) The object observing apparatus according to any one of preceding claims 1 to 3 and 5, further comprising
inspection conducting means for detecting a mirror reflection portion of said observation target portion based on data of the light received by said light receiving means, and inspecting said observation target portion for a defect based on a result of the detection.
21. (Amended) A method of observing an object comprising the steps of:
projecting light beams from light projecting means through a predetermined light path to an observation target portion of an object;
reflecting, in incident directions, the incoming light beams reflected by said observation target portion by a plurality of recursive reflecting means located at positions forming different elevation angles at a center of said observation target portion, respectively; and
receiving by light receiving means said light beams reflected by said plurality of recursive reflecting means and said observation target portion and coming through said predetermined light path.
22. The method of observing the object according to claim 21, wherein the light beams reflected by said observation target portion are reflected in the incident direction by said recursive reflecting means arranged annularly with respect to a center of said observation target portion.
23. The method of observing the object according to claim 21, wherein the light beams reflected by said observation target portion are reflected in the incident direction by said recursive reflecting means arranged in a doom-like form with respect to a center of said observation target portion.
24. (Canceled)
25. The method of observing the object according to claim 21, wherein the light beams reflected by said observation target portion are reflected in the incident directions by the plurality of recursive reflecting means arranged annularly with respect to a center of said observation target portion and located at positions forming different elevation angles at the center of said observation target portion, respectively.
26. (Amended) The method of observing the object according to any one of preceding claims 21 to 23 and 25, wherein said recursive reflecting means is operable to reflect the light beams of a specific wavelength reflected by said observation target portion, and reflects, in the incident direction, the specific wavelength component of the light beams reflected by said observation target portion.
27. The method of observing the object according to claim 21 or 23, wherein said recursive reflecting means is operable to change continuously a specific wavelength reflected thereby in accordance with the elevation angle at a center of said observation target portion, and reflects, in the incident direction, the wavelength component corresponding to said elevation angle of the light beams reflected by said observation target portion.
28. (Amended) The method of observing the object according to claim 25, wherein said recursive reflecting means is operable to reflect specific wavelengths partially differing from each other, and reflects, in the incident direction, the specific wavelength components of the light beams reflected by said observation target portion.
29. A method of observing an object comprising the steps of:
projecting white light beams to an observation target portion of an object through a predetermined light path from light projecting means having a white light source;
reflecting, in incident directions, by a plurality of recursive reflecting means red, green and blue wavelength components of said incoming white light beams reflected by said observation target portion, respectively, said plurality of recursive reflecting means being arranged annularly at positions forming different elevation angles at a center of said observation target portion; and
receiving by light receiving means the red, green and blue light beams reflected by said recursive reflecting means and said observation target portion and coming through said predetermined light path.
30. A method of observing an object comprising the steps of:
projecting white light beams from light projecting means having a white light source to an observation target portion of an object through a predetermined light path;
reflecting, in an incident direction, light beams of a specific wavelength of said incoming white light beams reflected by said observation target portion by recursive reflecting means arranged in a doom-like form with respect to a center of said observation target portion, said specific wavelength being variable in accordance with an elevation angle at a center of said observation target portion; and
receiving the light beams of said specific wavelength reflected by said recursive reflecting means and said observation target portion and coming through said predetermined light path.
31. A method of observing an object comprising the steps of:
projecting light beams of at least two color wavelength components simultaneously or with a predetermined time interval from light projecting means to an observation target portion of an object through a predetermined light path;
reflecting said at least two incoming color wavelength components reflected at said observation target portion by at least two recursive reflecting means arranged at positions forming different elevation angles at a center of said observation target portion; and
successively receiving, by light receiving means having a two-dimensional light receiving element, said at least two color wavelength components reflected by said recursive reflecting means and said observation target portion and coming through said predetermined light path.
32. A method of observing an object comprising the steps of:
successively projecting light beams of at least two light wavelength components with a predetermined time interval to an observation target portion of an object from light projecting means through a predetermined light path;
reflecting, in incident directions, said at least two incoming color wavelength components reflected by said observation target portion by at least two recursive reflecting means arranged at positions forming different elevation angles at a center of said observation target portion; and
successively receiving by light receiving means having a two-dimensional light receiving element said at least two color wavelength components reflected by said recursive reflecting means and said observation target portion and coming through said predetermined light path.
33. (Amended) The method of observing the object according to any one of preceding claims 21 to 23, 25 and 29 to 32, further comprising the steps of: detecting, by inspection conducting means, a mirror reflection portion of said observation target portion based on data of said light received by said light receiving means, and inspecting said observation target portion for a defect based on a result of said detection.
